# EUROPEAN PATENT APPLICATION

(11) **EP 4 184 598 A1**
(43) Date of publication of application: **24.05.2023**
(21) Application number: 22205972.7
(22) Date of filing: 08.11.2022
(51) Int. Cl.: H01L 33/44, H01L 33/48, H01L 33/52, H01L 33/00, H01L 33/62, H01L 33/38

(54) **ELECTRONIC STRUCTURE AND METHOD OF MANUFACTURING COMPLEX FILM**

(30) Priority: 17.11.2021 JP 2021187393
(71) Applicant: Oki Electric Industry Co., Ltd., Minato-ku Tokyo 105-8460 (JP)
(72) Inventor: FURUTA, Hironori, Tokyo, 105-8460 (JP); MATSUO, Genichirou, Tokyo, 105-8460 (JP); IINO, Akihiro, Tokyo, 105-8460 (JP); SUZUKI, Takahito, Tokyo, 105-8460 (JP); TANIGAWA, Kenichi, Tokyo, 105-8460 (JP); NAKAI, Yusuke, Tokyo, 105-8460 (JP); JUMONJI, Shinya, Tokyo, 105-8460 (JP); SHINOHARA, Yuuki, Tokyo, 105-8460 (JP)
(74) Representative: Betten & Resch

(57) **Abstract**

An electronic structure (1, 201, 301) includes a substrate (10) having a first surface (10A); a functional unit (2, 202, 302) including a functional section (13, 16, 14) that has an electronic function and a protective member (12, 17, 217) that protects the functional section (13, 16, 14) and having a second surface (2B) formed on the first surface (10A)'s side; and a support layer (11, 211, 311) provided at a position to contact the first surface (10A) and having a third surface (11A) in contact with the second surface (2B) of the functional unit (2), area of the third surface (11A) being smaller than area of the second surface (2B), wherein one of part of the functional unit (2, 202, 302) forming the second surface (2B) of the protective member (12, 17, 217) and part of the support layer (11, 211, 311) forming the third surface (11A) contains organic material as its principal component and the other contains inorganic material as its principal component.

## Description

### BACKGROUND OF THE INVENTION

### 1. Field of the Invention

The present disclosure relates to an electronic structure and a method of manufacturing a complex film.

### 2. Description of the Related Art

In general, an electronic circuit is manufactured by mounting electronic elements (referred to also as "devices") having various functions on a wiring substrate. In recent years, there has been developed a method of simplifying the mounting process by forming multiple types of electronic elements different from each other as one film and sticking the film on the wiring substrate.

As an example, in a display panel of the micro-LED (Light-Emitting Diode) type to be installed in a display device, one pixel is formed with light-emitting elements (LEDs) of three colors: red, green and blue, for example, and a great number of light-emitting elements are arranged in a grid on a circuit board. This display panel of the micro-LED type can be manufactured by, for example, forming the light-emitting elements of red, green and blue corresponding to one pixel as one complex film like a thin film and sticking the complex films on a wiring substrate in a grid.

As a method for manufacturing such a complex film, there has been proposed a method in which a sacrificial layer is formed on a substrate, a complex film including electronic elements is formed on the sacrificial layer, and thereafter part of the sacrificial layer is removed. See Fig. 1 to Fig. 9, etc. in Japanese Patent Application Publication No. 2017-108160 as Patent Reference 1, for example.

However, in such a method, projecting anchors are formed on a lower surface of the complex film in order to retain the complex film on the substrate at the time of etching. Therefore, this method has a problem in that it becomes necessary to execute a process of flattening a mounting surface of the complex film after peeling the complex film off of the substrate and that deteriorates the productivity.

### SUMMARY OF THE INVENTION

An object of the present disclosure is to provide an electronic structure and a method of manufacturing a complex film that make it possible to increase the productivity of complex films.

An electronic structure of the present disclosure includes a substrate having a first surface; a functional unit including a functional section that has an electronic function and a protective member that protects the functional section and having a second surface formed on the first surface's side; and a support layer provided at a position to contact the first surface and having a third surface in contact with the second surface of the functional unit, area of the third surface being smaller than area of the second surface, wherein one of part of the functional unit forming the second surface of the protective member and part of the support layer forming the third surface contains organic material as its principal component and the other contains inorganic material as its principal component.

A method of manufacturing a complex film of the present disclosure includes forming a substrate having a first surface; forming a support layer having a third surface on the first surface; forming a complex film, including a functional section that has an electronic function and a protective member that protects the functional section and having a second surface formed on the third surface's side, on the support layer; and removing part of the support layer and thereby making area of the third surface, in contact with the complex film in remaining part of the support layer, smaller than area of the second surface, wherein one of part of the complex film forming the second surface of the protective member and part of the support layer forming the third surface contains organic material as its principal component and the other contains inorganic material as its principal component.

According to the present disclosure, an electronic structure and a method of manufacturing a complex film capable of increasing the productivity of complex films can be realized.

### BRIEF DESCRIPTION OF THE DRAWINGS

The present disclosure will become more fully understood from the detailed description given hereinbelow and the accompanying drawings which are given by way of illustration only, and wherein:
Figs. 1A and 1B are a schematic plan view and a schematic cross-sectional view showing the configuration of an electronic structure according to a first embodiment;
Fig. 2 is a flowchart showing a manufacture peeling mounting procedure according to the first embodiment;
Figs. 3A to 3G are schematic cross-sectional views showing manufacture of the electronic structure according to the first embodiment;
Figs. 4A to 4E are schematic cross-sectional views showing the manufacture of the electronic structure and peeling and mounting of a complex film according to the first embodiment;
Figs. 5A and 5B are a schematic plan view and a schematic cross-sectional view showing the configuration of an electronic structure according to a second embodiment;
Fig. 6 is a flowchart showing a manufacture peeling mounting procedure according to the second embodiment;
Figs. 7A to 7G are schematic cross-sectional views showing manufacture of the electronic structure according to the second embodiment;
Figs. 8A to 8E are schematic cross-sectional views showing the manufacture of the electronic structure and the peeling and the mounting of a complex film according to the second embodiment;
Figs. 9A and 9B are a schematic plan view and a schematic cross-sectional view showing the configuration of an electronic structure according to a third embodiment;
Figs. 10A and 10B are schematic cross-sectional views showing the mounting of complex films according to the third embodiment; and
Fig. 11 is a schematic cross-sectional view showing the configuration of an electronic structure according to another embodiment.

### DETAILED DESCRIPTION OF THE INVENTION

Further scope of applicability of the present disclosure will become apparent from the detailed description given hereinafter. However, it should be understood that the detailed description and specific examples, while indicating embodiments of the present disclosure, are given by way of illustration only, and various changes and modifications will become apparent to those skilled in the art from the detailed description.

### [1. First Embodiment]

### [1-1. Configuration of Electronic Structure and Complex Film]

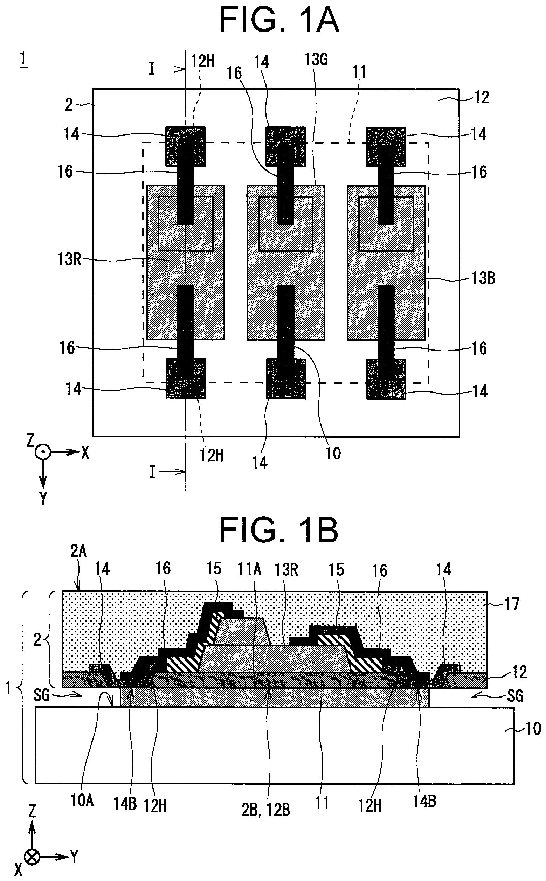

Fig. 1A is a schematic plan view showing the configuration of an electronic structure 1 and a complex film 2 according to a first embodiment. Fig. 1B is a schematic cross-sectional view showing a cross section at the line I-I in Fig. 1A. The electronic structure 1 has a configuration in which a support layer 11 is provided on a formation substrate 10 and the complex film 2 is stuck on an upper side of the support layer 11.

For convenience of description, in the first embodiment, a direction heading from the left to the right in Fig. 1A is represented as an X direction, a direction heading from the top to the bottom in Fig. 1A is represented as a Y direction, and a direction heading from the back to the front of the sheet of Fig. 1A is represented as a Z direction. Further, for convenience, a Z direction side (i.e., a surface facing the Z direction) and an opposite side (i.e., a surface facing the -Z direction) of each part are respectively referred to also as a "front side" and a "back side".

On the complex film 2, the length of a side extending in the X direction or the Y direction is approximately 30 [µm] to 50 [µm] and the length of a side extending in the Z direction is approximately 1 [µm] to 15 [µm], for example. The complex film 2 has a configuration in which light-emitting elements of three colors: red (R), green (G) and blue (B), are arranged to be successively aligned in the X direction, wiring members and connection terminals are connected to each of the light-emitting elements, and the components are integrated into one film-like package. Specifically, the complex film 2 includes a base film 12, light-emitting elements 13 (13R, 13G and 13B), connection pads 14, insulation films 15, wiring parts 16 and a cover layer 17 as main components.

For convenience of description, the complex film 2 is hereinafter referred to also as a "functional unit" or "functional film" or "composite film", the light-emitting element 13 is hereinafter referred to also as a "functional element", and the connection pad 14 is hereinafter referred to also as a "conductive member". Further, since the light-emitting elements 13, the wiring parts 16 and the connection pads 14 have an electronic function of "emitting light in response to the supply of electric current", these components are hereinafter referred to collectively as a "functional section". Furthermore, in the complex film 2, parts regarding the light-emitting elements 13 of the respective colors are configured in the same way as each other. Therefore, the following description will be given mainly of the part regarding the light-emitting element 13R of red color and the description is partially omitted for the light-emitting element 13G of green color and the light-emitting element 13B of blue color.

As shown in Fig. 1B, the complex film 2 is overlaid on the Z direction side (i.e., front side) of the formation substrate 10 and the support layer 11, and the entirety of the complex film 2, the formation substrate 10 and the support layer 11 forms the electronic structure 1. The formation substrate 10 is a plate-like member made of inorganic material and has sufficient strength. Specifically, as the formation substrate 10, plate-like members made of various inorganic materials are usable, such as a silicon substrate made of silicon (Si), a glass substrate, a sapphire substrate or the like, for example. A formation substrate front surface 10A as a front surface of the formation substrate 10 is formed extremely flat and its surface roughness (roughness) is less than or equal to 10 [nm]. The formation substrate front surface 10A is hereinafter referred to also as a "first surface".

The support layer 11 is made of inorganic material such as silicon oxide (SiO₂) or silicon nitride (SiN), for example, in a shape like a thin film. On the support layer 11, a support layer front surface 11A as a front surface of the support layer 11 is formed extremely flat similarly to the front surface of the formation substrate 10 and its surface roughness is less than or equal to 10 [nm].

On the complex film 2, a complex film back surface 2B as a back surface of the complex film 2 is placed in contact with the support layer front surface 11A in a relatively wide area. Accordingly, the complex film back surface 2B, which is formed in the state of being in contact with the support layer front surface 11A, is extremely smooth similarly to the support layer front surface 11A and its surface roughness is less than or equal to 10 [nm]. In the following description, the complex film back surface 2B is referred to also as a "second surface" and the support layer front surface 11A is referred to also as a "third surface".

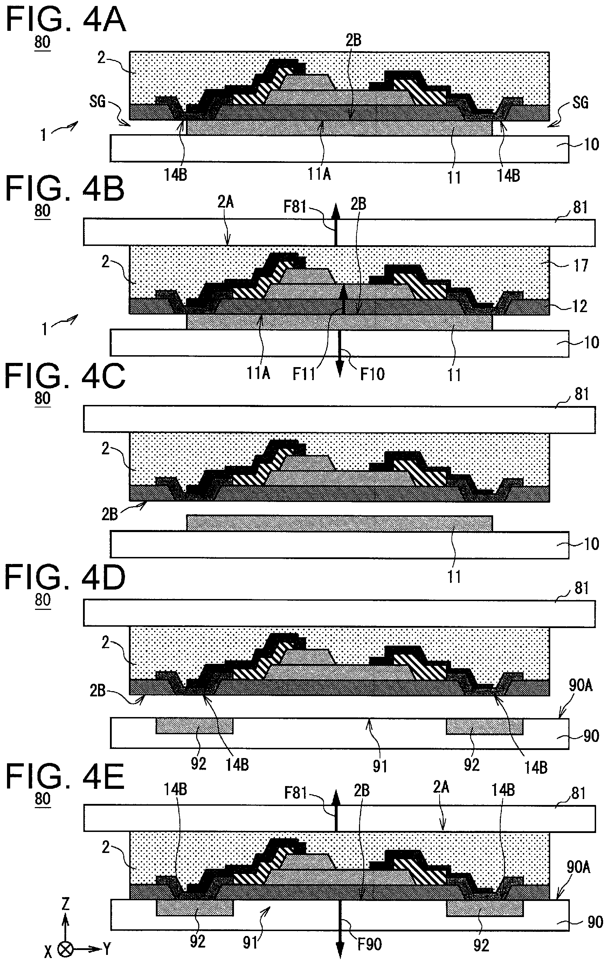

Further, both of the formation substrate 10 and the support layer 11 are used in the manufacturing stage of the complex film 2, and the complex film 2 is completed by peeling the complex film 2 off of the support layer 11. The completed complex film 2 is mounted on a wiring substrate which will be described later (e.g., wiring substrate 90 in Fig. 4D which will be explained later).

Namely, the electronic structure 1 is in a state in which the complex film 2 is still sticking on the support layer 11 and the formation substrate 10 and just before completion. With such a configuration of the electronic structure 1, it is possible during conveyance/transportation, storage, etc. to handle the complex film 2 with ease as a member integrated with the formation substrate 10 while also protecting the complex film back surface 2B.

The base film 12 is made of organic material such as polyimide resin, acrylic resin or epoxy resin, for example, and has an insulating property. The base film 12 is formed in a shape like a flat rectangular prism or a thin flat plate as a whole, and a side extending in the Z direction is far shorter compared to a side extending in the X direction and a side extending in the Y direction. A surface of the base film 12 on the back side is hereinafter referred to as a "base film back surface 12B". The base film back surface 12B is formed extremely flat and its surface roughness (roughness) is less than or equal to 10 [nm].

Further, the base film 12 is formed to be larger than the support layer 11 in regard to the X direction and the Y direction, and sticks out from the support layer 11 in the X direction, the -X direction, the Y direction and the -Y direction. Put another way, the support layer 11 is formed to be one step smaller than the base film 12 in regard to the X direction and the Y direction. Specifically, on an XY plane, the outline of the support layer 11 is situated on the inner side of the outline of the base film 12 by approximately 5 [µm]. Accordingly, in the electronic structure 1, a support gap SG is formed at each part that is on the outer side of the support layer 11 and on the inner side of the base film 12 on an XY plane and between the formation substrate 10 and the base film 12 in regard to the Z direction.

Furthermore, in part of the base film 12 relatively on the Y direction side (lower side in Fig. 1A), square-shaped connection holes 12H penetrating the base film 12 in the Z direction are formed respectively at three positions separate from each other in the X direction. Further, in part of the base film 12 relatively on the -Y direction side (upper side in Fig. 1A), square-shaped connection holes 12H penetrating the base film 12 in the Z direction are also formed respectively at three positions separate from each other in the X direction.

The light-emitting element 13R of the red color is an electronic element made of gallium arsenide (GaAs)-based material, for example, and is a functional element that forms a light-emitting diode of the red color. The light-emitting element 13R of the red color is provided at a position on the front surface of the base film 12 that is on the -X direction side and in the vicinity of a center in regard to the Y direction. Parenthetically, on a surface of the light-emitting element 13R on the Z direction side, part on the -Y direction side is an anode terminal and part on the Y direction side is a cathode terminal.

The light-emitting element 13G of the green color is an electronic element made of gallium nitride (GaN)-based material, for example, and is a functional element that forms a light-emitting diode of the green color. The light-emitting element 13G is formed in the same shape as the light-emitting element 13R and is arranged at a position on the front surface of the base film 12 that is slightly separate from the light-emitting element 13R towards the X direction side.

The light-emitting element 13B of the blue color is an electronic element made of GaN-based material, for example, and is a functional element that forms a light-emitting diode of the blue color. The light-emitting element 13B is formed in the same shape as the light-emitting element 13R and is arranged at a position on the front surface of the base film 12 that is slightly separate from the light-emitting element 13G towards the X direction side. As above, the complex film 2 is provided with two or more types of functional elements different from each other.

Each connection pad 14 is, for example, a thin film made of metallic material, namely, a metallic film, having electrical conductivity such as gold (Au), platinum (Pt) or alloy containing at least one of Au and Pt. The connection pad 14 is provided so as to fill in the inside of the connection hole 12H in the base film 12 while stepping over to the front surface's side of the base film 12 in the vicinity of an outer periphery of the connection hole 12H. Namely, one connection pad 14 is arranged on each of the Y direction side and the -Y direction side of the light-emitting element 13R. On the connection pad 14, a connection pad back surface 14B as a surface on the -Z direction side is formed extremely flat similarly to the base film back surface 12B and its surface roughness (roughness) is less than or equal to 10 [nm]. The connection pad back surface 14B is hereinafter referred to also as a "fourth surface".

On the complex film 2, the base film back surface 12B and the connection pad back surface 14B form a substantially continuous plane, and this plane is the complex film back surface 2B. On the complex film back surface 2B, the distance between the base film back surface 12B and the connection pad back surface 14B in regard to the Z direction, namely, a "step height", is extremely small. Specifically, the step height on the complex film back surface 2B is less than or equal to 1/1000 in comparison with the shortest side in the outline of the complex film 2 on an XY plane, namely, the shorter one of the length of a side extending in the X direction and the length of a side extending in the Y direction.

The insulation film 15 is made of material having the insulating property such as silicon oxide (SiO₂), for example. The light-emitting element 13R is provided with two insulation films 15, specifically, one insulation film 15 on each of the Y direction side and the -Y direction side of the light-emitting element 13R, and the insulation films 15 mainly cover side faces of the light-emitting element 13R on the -Y direction side and the Y direction side and their vicinity.

The wiring part 16 is made of, for example, metallic material having electrical conductivity such as Au, aluminum (Al), copper (Cu), titanium (Ti) or Pt. The wiring part 16 is provided on each of the -Y direction side and the Y direction side of the light-emitting element 13R and electrically connects the light-emitting element 13R with each connection pad 14.

The cover layer 17 is made of organic material such as polyimide resin similarly to the base film 12 and is provided to cover upper parts of the base film 12, the light-emitting elements 13, the connection pads 14, the insulation films 15 and the wiring parts 16. A front surface of the cover layer 17, namely, a front surface of the complex film 2 (hereinafter referred to also as a "complex film front surface 2A"), is formed flat on the whole. In the following description, the base film 12 and the cover layer 17 are referred to also as a "protective member".

As above, in the complex film 2, the light-emitting elements 13 for the three colors are aligned on the front surface's side of the base film 12, and the connection pad back surfaces 14B of the connection pads 14 electrically connected to each light-emitting element 13 form a plane substantially the same as the base film back surface 12B.

Incidentally, in the electronic structure 1, the base film 12 and the cover layer 17 are both made of organic material. Therefore, the base film 12 and the cover layer 17 form relatively strong bonds such as covalent bonds or hydrogen bonds on the molecular level. Further, in the electronic structure 1, the formation substrate 10 and the support layer 11 are both made of inorganic material. Therefore, the formation substrate 10 and the support layer 11 form relatively strong bonds such as covalent bonds or hydrogen bonds on the molecular level.

In contrast, in the electronic structure 1, the support layer 11 is made of inorganic material whereas the base film 12 is made of organic material. Therefore, the support layer 11 and the base film 12 form relatively weak bonds like Van der Waals force on the molecular level. Further, in the electronic structure 1, the outline of the support layer 11 is formed to be one step smaller than the outline of the base film 12 on an XY plane. Therefore, a contact area of the support layer 11 and the base film 12 is slightly smaller than a total area of the base film 12.

To sum up, in the electronic structure 1, the force acting between the support layer 11 and the base film 12 is the smallest among various types of force acting between stacked layers. Thus, in the electronic structure 1, if sufficiently strong force in the Z direction is applied to the cover layer 17 in a state in which the formation substrate 10 is fixed, separation occurs between the support layer 11 and the base film 12, and the complex film 2 peels from the formation substrate 10 and the support layer 11.

### [1-2. Manufacture of Electronic Structure and Peeling and Mounting of Complex Film]

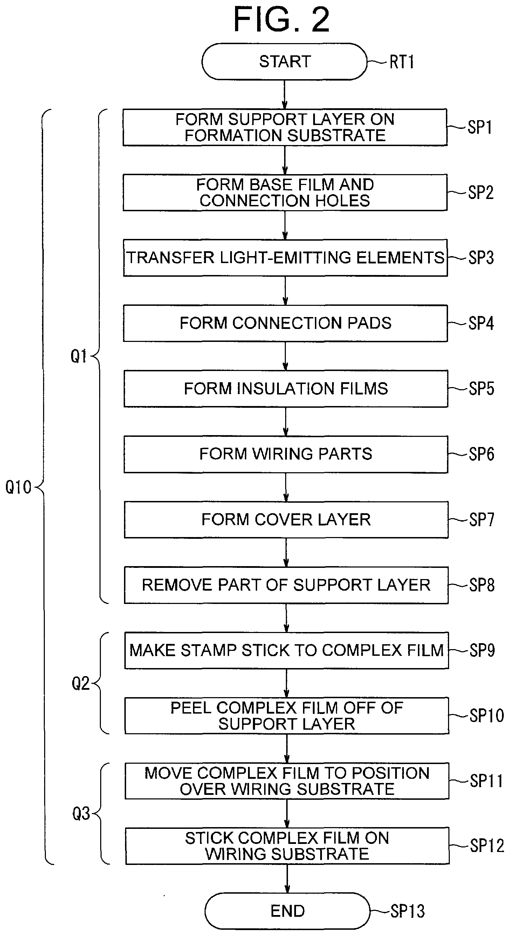

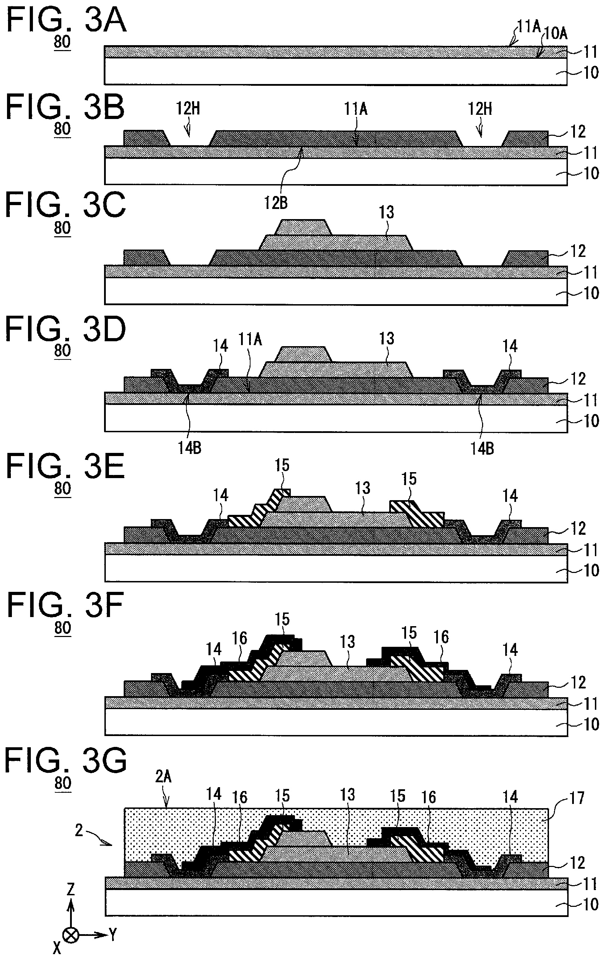

Next, the manufacture of the electronic structure 1 and the peeling and the mounting of the complex film 2 will be described below with reference to Fig. 2, Figs. 3A to 3G and Figs. 4A to 4E. Fig. 2 is a flowchart showing a manufacture peeling mounting procedure in regard to the manufacture of the electronic structure 1 and the peeling and the mounting of the complex film 2. Figs. 3A to 3G and Figs. 4A to 4E are schematic cross-sectional views showing processes on the electronic structure 1 and the complex film 2 stepwise. Here, the Z direction side is represented also as an "upper side", and the -Z direction side is represented also as a "lower side".

The electronic structure 1 is manufactured by a prescribed manufacture peeling mounting apparatus 80 according to various processes similar to those used when manufacturing generic semiconductors, so as to overlay layers on the formation substrate 10 stepwise. Further, subsequently by the manufacture peeling mounting apparatus 80, the complex film 2 as part of the electronic structure 1 is peeled off of the support layer 11 and then mounted on the wiring substrate 90 which will be described later according to various processes similar to those used when manufacturing or mounting generic semiconductors.

Specifically, the manufacture peeling mounting apparatus 80 starting the manufacture peeling mounting procedure RT1 (Fig. 2) advances to the first step SP1, forms the support layer 11 on the formation substrate front surface 10A of the formation substrate 10 as shown in Fig. 3A, and advances to the next step SP2. Specifically, the manufacture peeling mounting apparatus 80 forms the thin film-like support layer 11 made of inorganic material by using CVD (Chemical Vapor Deposition) (not shown) or the like, for example. At that time, the support layer front surface 11A is formed extremely flat similarly to the formation substrate front surface 10A.

In the step SP2, the manufacture peeling mounting apparatus 80 forms the base film 12 as shown in Fig. 3B, and advances to the next step SP3. Specifically, the manufacture peeling mounting apparatus 80 forms the thin film-like base film 12 made of organic material on the support layer front surface 11A while forming the connection holes 12H by executing a commonly known patterning process such as lithography, for example. At that time, the base film back surface 12B of the base film 12 is formed in the state of being in contact (close contact) with the support layer front surface 11A, and thus is formed extremely flat similarly to the support layer front surface 11A.

In the step SP3, the manufacture peeling mounting apparatus 80 provides the light-emitting elements 13 on the base film 12 as shown in Fig. 3C, and advances to the next step SP4. The light-emitting elements 13 are manufactured separately by a prescribed LED manufacturing apparatus (not shown) or the like. The manufacture peeling mounting apparatus 80 transfers the light-emitting elements 13 to prescribed positions on the base film 12 by using a commonly known transfer technology.

In the step SP4, the manufacture peeling mounting apparatus 80 forms the connection pads 14 on parts of the base film 12 in the vicinity of the connection holes 12H as shown in Fig. 3D, and advances to the next step SP5. Specifically, the manufacture peeling mounting apparatus 80 forms the connection pads 14 by depositing metallic material such as Au or Pt like thin films in ranges on the base film 12 surrounding the peripheries of the connection holes 12H by a method like lithography or vapor deposition, for example. At that time, the connection pad back surface 14B of the connection pad 14 is formed in the state of being in contact (close contact) with the support layer front surface 11A similarly to the base film back surface 12B of the base film 12, and thus becomes extremely smooth.

In the step SP5, the manufacture peeling mounting apparatus 80 forms the insulation films 15 with material having the insulating property so as to overlap with parts of the light-emitting elements 13 and parts of the base film 12 as shown in Fig. 3E, and advances to the next step SP6. In the step SP6, the manufacture peeling mounting apparatus 80 forms the wiring parts 16 with material having electrical conductivity so as to overlap with parts of the light-emitting elements 13, parts of the insulation films 15 and parts of the connection pads 14 as shown in Fig. 3F, and advances to the next step SP7. Parenthetically, in the steps SP5 and SP6, the manufacture peeling mounting apparatus 80 can use a method like photolithography or vapor deposition, for example.

In the step SP7, the manufacture peeling mounting apparatus 80 completes the complex film 2 by forming the cover layer 17 with organic material so as to cover the upper side of the base film 12 and the like as shown in Fig. 3G, and advances to the next step SP8. At that time, the complex film 2 is in a state of having been stuck on the support layer front surface 11A of the support layer 11.

In the step SP8, the manufacture peeling mounting apparatus 80 forms the support gaps SG by removing parts of the support layer 11 as shown in Fig. 4A, and advances to the next step SP9. Specifically, the manufacture peeling mounting apparatus 80 forms the support gaps SG by removing parts of the support layer 11 in the vicinity of or outside an outer peripheral part of the complex film 2, by executing an etching process by use of a prescribed chemical solution. In other words, in the step SP8, part of the support layer 11 is removed, thereby making area of the third surface 11A, in contact with the functional unit 2 in remaining part of the support layer 11, smaller than area of the second surface 2B.

As above, the manufacture peeling mounting apparatus 80 is capable of manufacturing the electronic structure 1 by the steps from the step SP1 to the step SP8. These steps are hereinafter referred to as a "manufacturing step set Q1".

In the step SP9, the manufacture peeling mounting apparatus 80 makes a stamp 81 having a sticking function stick to the complex film front surface 2A as shown in Fig. 4B, and advances to the next step SP10. Here, the electronic structure 1 with the stamp 81 sticking thereto is, roughly classified, in a state in which four types of objects: the formation substrate 10, the support layer 11, the complex film 2 and the stamp 81, are successively overlaid in the Z direction.

In this state, magnitudes of sticking force at three parts adjoining each other differ from each other. As mentioned earlier, relatively strong sticking force F10 acts between the formation substrate 10 and the support layer 11 both made of inorganic material. Further, relatively strong sticking force F81 acts between the stamp 81 and the complex film front surface 2A since the complex film front surface 2A substantially in its whole range is in contact with the stamp 81.

In contrast, relatively weak sticking force F11 acts between the support layer 11 being inorganic material and the base film 12 being organic material due to the relatively small area of the support layer 11, the acting of Van der Waals force, and so forth. Namely, the sticking force F11 is weaker than both of the sticking force F10 and the sticking force F81.

In the step SP10, the manufacture peeling mounting apparatus 80 shifts the stamp 81 in the Z direction in a state in which the formation substrate 10 is fixed by a prescribed fixation jig (not shown), and advances to the next step SP11. Accordingly, in the electronic structure 1 with the stamp 81 sticking thereto, peeling occurs at the part where the sticking force is the weakest, namely, between the base film 12 and the support layer 11, as shown in Fig. 4C and the complex film 2 is separated from the support layer 11 and the formation substrate 10.

Parenthetically, in each of the base film 12 and the support layer 11, its molecules have formed a structure having sufficient strength. Therefore, with the complex film 2, it is impossible that part of the base film 12 separates from the base film 12 and remains on the support layer 11's side or part of the support layer 11 separates from the support layer 11 and remains stuck on the base film 12's side, and the base film back surface 12B can be set in an extremely flat condition.

As above, the manufacture peeling mounting apparatus 80 is capable of peeling the complex film 2 in the electronic structure 1 from the formation substrate 10 and the support layer 11 by the steps from the step SP9 to the step SP10. These steps are hereinafter referred to as a "peeling step set Q2".

In the step SP11, the manufacture peeling mounting apparatus 80 places the complex film 2 at a position on the upper side (Z direction side) of the wiring substrate 90 by shifting the stamp 81 as shown in Fig. 4D, and advances to the next step SP12.

Here, the wiring substrate 90 is a substrate that has been manufactured separately as a circuit board formed principally of glass epoxy, for example, and a mounting part 91 on which the complex film 2 should be mounted has been set on a wiring substrate front surface 90A (hereinafter referred to also as a "wiring substrate surface") as the wiring substrate 90's front surface on the Z direction side. In the mounting part 91, electrodes 92 are arranged respectively at positions corresponding to the connection pad back surfaces 14B on the complex film back surface 2B of the complex film 2 and a wiring pattern is formed properly with non-illustrated wiring material. Further, the wiring substrate front surface 90A as the front surface of the wiring substrate 90 is formed extremely flat and its surface roughness is less than or equal to 10 [nm].

The manufacture peeling mounting apparatus 80 places the complex film back surface 2B at a position that is slightly separate from the mounting part 91 on the wiring substrate front surface 90A towards the Z direction side by properly moving the stamp 81, and thereby makes the connection pad back surfaces 14B respectively face the electrodes 92.

In the step SP12, the manufacture peeling mounting apparatus 80 sticks the complex film 2 on the wiring substrate 90 by shifting the stamp 81 as shown in Fig. 4E, and advances to the next step SP13.

Specifically, the manufacture peeling mounting apparatus 80 first moves the stamp 81 in the -Z direction and thereby places the complex film back surface 2B in contact with the mounting part 91 of the wiring substrate front surface 90A. By this operation, it is possible to make intermolecular force act between the complex film 2 and the wiring substrate 90 and thereby stick the complex film 2 on the mounting part 91 of the wiring substrate 90.

At that time, on the complex film 2, the complex film back surface 2B and the wiring substrate front surface 90A are both extremely flat and the complex film back surface 2B in its whole range is in contact with the wiring substrate front surface 90A. Accordingly, sticking force F90 acting between the complex film 2 and the wiring substrate 90 becomes relatively strong and exceeds the sticking force F81 of the stamp 81.

Thereafter, the manufacture peeling mounting apparatus 80 moves the stamp 81 in the Z direction. At that time, the stamp 81 is separated from the complex film 2 since the sticking force F81 is weaker than the sticking force F90. Consequently, the manufacture peeling mounting apparatus 80 is capable of sticking the complex film back surface 2B of the complex film 2 on the wiring substrate front surface 90A of the wiring substrate 90, namely, mounting the complex film 2 on the wiring substrate 90.

As above, the manufacture peeling mounting apparatus 80 is capable of mounting the complex film 2 on the wiring substrate 90 by the steps from the step SP11 to the step SP12. These steps are hereinafter referred to as a "mounting step set Q3".

In the step SP13, the manufacture peeling mounting apparatus 80 ends the manufacture peeling mounting procedure RT1. For convenience of description, the manufacturing step set Q1 from the step SP1 to the step SP8, the peeling step set Q2 from the step SP9 to the step SP10, and the mounting step set Q3 from the step SP11 to the step SP12 are hereinafter referred to collectively as a "manufacture peeling mounting step set Q10".

Incidentally, the above description has been given of the case where one manufacture peeling mounting apparatus 80 executes all of the manufacturing step set Q1, the peeling step set Q2 and the mounting step set Q3 of the manufacture peeling mounting procedure RT1, namely, the case where one manufacture peeling mounting apparatus 80 executes all of the manufacture of the electronic structure 1 and the peeling and the mounting of the complex film 2.

However, in the first embodiment, it is also possible, for example, to make a prescribed manufacturing apparatus execute the manufacturing step set Q1 and make a mounting apparatus installed in a place separate from the manufacturing apparatus execute the peeling step set Q2 and the mounting step set Q3. In this case, the electronic structure 1 may be conveyed from the manufacturing apparatus to the mounting apparatus after the completion of the electronic structure 1 by the manufacturing step set Q1.

### [1-3. Effect and Other Features]

In the above-described configuration, the electronic structure 1 according to the first embodiment is made by forming the formation substrate 10 and the support layer 11 stacked in a lower side with inorganic material while forming the base film 12 and the cover layer 17 of the complex film 2 stacked in an upper side with organic material. Further, in the electronic structure 1, the outline of the support layer 11 is formed to be one step smaller than the outline of the base film 12 (Fig. 1).

Accordingly, in the electronic structure 1, the sticking force acting between the complex film back surface 2B and the support layer front surface 11A can be held down below the sticking force in the other parts. With this feature, in the electronic structure 1, when force is applied to the complex film 2 in a direction of separating from the formation substrate 10, the complex film 2 can be easily separated from the support layer 11 and easily peeled off of the support layer 11 (Figs. 4B and 4C) .

Especially, the electronic structure 1 is configured so as to adjust the sticking force acting between the complex film 2 and the support layer 11 by successively stacking the formation substrate 10, the support layer 11 and the complex film 2 and thereafter removing part of the support layer 11 in the vicinity of its outer periphery by the etching process (Fig. 1B). Accordingly, during storage and conveyance, the electronic structure 1 can be maintained in the state in which the complex film 2 is sticking to the formation substrate 10 and the support layer 11, and the complex film back surface 2B can be prevented from being damaged and its smoothness can be maintained excellently. On the other hand, when the stamp 81 is used, in the electronic structure 1, the complex film 2 can be easily peeled from the formation substrate 10 and the support layer 11, and can be excellently stuck on the wiring substrate 90 thanks to the complex film back surface 2B maintained extremely smooth.

Here, it is assumed a case where the outline of the support layer 11 is made larger than or equal to the outline of the complex film 2 in a virtual electronic structure and the sticking operation with the support layer 11 occurs in the whole range of the complex film back surface 2B. In this virtual electronic structure, when the area of the complex film 2 is relatively large due to largeness of the light-emitting elements 13 or the like, there is a danger that the sticking force acting on the entire complex film 2 becomes excessive and the complex film 2 cannot be peeled off of the support layer 11 by use of the stamp 81.

In contrast, in the electronic structure 1 according to the first embodiment, the sticking force is intentionally decreased by reducing the contact area of the support layer 11 and the complex film 2 by removing the vicinity of the outer periphery of the support layer 11 by the etching process. Accordingly, in the electronic structure 1, even supposing that the total area of the complex film 2 is necessitated to be large due to large areas of the light-emitting elements 13, the connection pads 14 or the like, the magnitude of the sticking force can be adjusted appropriately by properly reducing the area of the support layer 11.

Further, in the electronic structure 1, the base film 12 and the cover layer 17 of the complex film 2 being finally necessary are made of organic material, while the formation substrate 10 and the support layer 11 being finally unnecessary are made of inorganic material. Accordingly, in the electronic structure 1, by using an appropriate etching solution in the step of executing the etching process, the inorganic material can be removed, practically without damaging the organic material, namely, a selection ratio of the etching can be secured.

From another viewpoint, in the electronic structure 1, organic material and inorganic material are placed in contact with each other in the boundary part between the support layer 11 and the base film 12 as part where the peeling occurs in a later step, by which the sticking force between the support layer 11 and the base film 12 is set relatively weak. Accordingly, in the electronic structure 1, just by displacing the complex film front surface 2A so as to separate from the formation substrate 10 in the peeling step set Q2 (Fig. 2 and Figs. 4A to 4E), the support layer 11 and the base film 12 can be excellently separated from each other and the complex film back surface 2B can be made extremely flat.

Furthermore, in the manufacturing steps of the electronic structure 1, the front surface of the formation substrate 10 is formed extremely smooth and the support layer front surface 11A of the support layer 11 overlaid on the formation substrate 10 is also formed extremely smooth, and thus the base film back surface 12B of the base film 12 stacked on the support layer front surface 11A is also formed extremely smooth.

Namely, in the electronic structure 1, when the complex film 2 is peeled from the formation substrate 10 and the support layer 11, the complex film back surface 2B can be set in an extremely flat condition. Accordingly, just by sticking the complex film 2 peeled from the electronic structure 1 on the wiring substrate front surface 90A of the wiring substrate 90, sufficiently strong sticking force can be generated and necessary electrical continuity can be obtained.

Further, in its manufacturing steps, the complex film 2 is manufactured so as to successively stack parts on the front surface of the formation substrate 10 formed extremely flat (Figs. 3A to 3G and Figs. 4A to 4E). Accordingly, the complex film 2 can be manufactured with ease so as to set the complex film back surface 2B in an extremely flat condition, namely, make the base film back surface 12B and the connection pad back surface 14B both extremely flat and hold down the step (level difference) between the base film back surface 12B and the connection pad back surface 14B to be extremely small, without the need of executing a process for specially flattening the complex film back surface 2B.

Put another way, in the electronic structure 1, the complex film back surface 2B can be formed extremely smooth by a markedly easy process compared to cases of forming anchors on the lower surface of the complex film and executing the flattening by removing the anchors as in the Patent Reference 1.

Incidentally, the electronic structure 1 in the etching process can fall into a condition in which projections and depressions have been formed (i.e., rough condition) due to reaction of the etching solution with surfaces of parts of the connection pads 14 exposed to the inside of the support gap SG. However, the electronic structure 1 is configured to leave at least part of the connection pad 14 in contact with the support layer 11 (e.g., Fig. 1B) when outline parts of the support layer 11 are removed by the etching process. Therefore, at least part of the connection pad 14 can be maintained in the flat condition on the complex film 2 separated from the electronic structure 1, sufficiently strong sticking force can be made to act between the connection pad 14 and the electrode 92 of the wiring substrate 90, and the electrical continuity can be achieved excellently.

Further, in the electronic structure 1, the connection pad 14 is made of metallic material having extremely low ionization tendency and having electrical conductivity such as Au or Pt. Accordingly, in the electronic structure 1, even when the etching solution contacts the connection pad 14 in the etching process for removing part of the support layer 11, the degree of damage to the surface of the connection pad 14 can be held extremely low and the smoothness can be maintained excellently.

Incidentally, there are cases where an adhesive agent is used when bonding two objects together. There are adhesive agents that exhibit the adhesive function by using intermolecular force. Further, in general, an adhesive agent is in the form of liquid and two objects are brought to the bonded state by applying the adhesive agent on bonding surfaces of the objects and hardening the adhesive agent in a state of having been sandwiched between the objects. When such an adhesive agent is used, in order to peel the already bonded objects from each other, it is necessary to physically destroy the hardened adhesive agent and there is a danger of damaging the objects at the time of the destruction.

Further, for example, in part where electrical joining is required such as a joint between an electrode of the wiring substrate and an electrode of an element, alloy due to eutectic crystallization of the electrodes is formed by means of bump connection in many cases. In such cases, while it is also possible, for example, to remove the bump connection by means of laser removal or the like, that causes considerable damage especially to the electrode of the wiring substrate.

In contrast, in the first embodiment, such an adhesive agent is not used and physical and electrical connections are realized by placing the complex film back surface 2B of the complex film 2 and the wiring substrate front surface 90A of the wiring substrate 90 in direct contact with each other and making intermolecular force act between the complex film back surface 2B and the wiring substrate front surface 90A. Thus, in the first embodiment, when a defective part is detected after the mounting of the complex film 2 on the wiring substrate 90, the complex film 2 can be peeled off with extreme ease practically without damaging the wiring substrate 90, and a new complex film 2 can be stuck on the same position.

With the configuration described above, in the electronic structure 1 according to the first embodiment, the formation substrate 10 and the support layer 11 are formed with inorganic material while the base film 12 and the cover layer 17 of the complex film 2 are formed with organic material, and the outline of the support layer 11 is formed to be smaller than the outline of the base film 12. Therefore, the electronic structure 1 is capable of appropriately adjusting the sticking force acting between the complex film back surface 2B and the support layer front surface 11A so that the peeling does not occur during storage and conveyance and the peeling can be executed with ease by using the stamp 81 before the mounting. Accordingly, with the electronic structure 1, storage and conveyance can be done while maintaining the smoothness of the complex film back surface 2B, and the peeling of the complex film 2 off of the support layer 11 and the mounting of the complex film 2 on the wiring substrate 90 can also be executed with ease.

### [2. Second Embodiment]

### [2-1. Configuration of Electronic Structure and Complex Film]

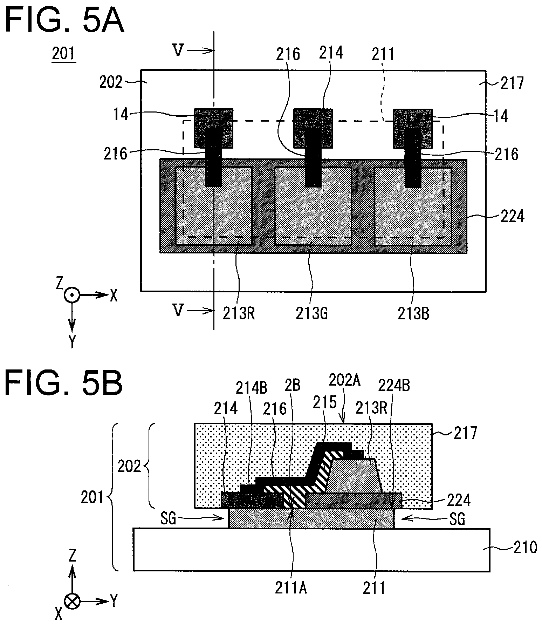

Fig. 5A corresponding to Fig. 1A is a schematic plan view showing the configuration of an electronic structure 201 and a complex film 202 according to a second embodiment. Fig. 5B corresponding to Fig. 1B is a schematic cross-sectional view showing a cross section at the line V-V in Fig. 5A. In the second embodiment, each of the X direction, the Y direction and the Z direction is defined in the same way as in the first embodiment.

The electronic structure 201 has a configuration in which a support layer 211 formed in the same way as the support layer 11 is provided on a formation substrate 210 formed in the same way as the formation substrate 10 and the complex film 202 is stuck on the upper side of the support layer 211. A support layer front surface 211A is formed extremely smooth similarly to the support layer front surface 11A. The complex film 302 is hereinafter referred to also as a "functional unit" or "functional film" or "composite film."

The complex film 202 has a configuration partially similar to that of the complex film 2 according to the first embodiment (Fig. 1A, Fig. 1B, etc.). Namely, the complex film 202 has a configuration in which light-emitting elements of three colors: red (R), green (G) and blue (B), are arranged to be successively aligned in the X direction, wiring members and connection terminals are connected to each of the light-emitting elements, and the components are integrated into one film-like package. Specifically, the complex film 202 is formed with light-emitting elements 213 (213R, 213G and 213B), connection pads 214, insulation films 215, wiring parts 216, a cover layer 217 and a lower electrode 224.

The lower electrode 224 is a component provided in place of the connection pads' 14 in the first embodiment respectively provided on the Y direction side of the light-emitting elements 13 of the respective colors, and is formed with the same material as the connection pads 14. A lower electrode back surface 224B as a back surface of the lower electrode 224 is in contact with the support layer front surface 211A and is formed like a thin plate being thin in the Z direction. Further, the lower electrode 224 has a shape formed by interconnecting and integrating parts corresponding to the light-emitting elements 213 of the respective colors in the X direction.

While each light-emitting element 213 (213R, 213G, 213B) is respectively made of the same material as the light-emitting element 13 (13R, 13G, 13B) according to the first embodiment, the shape is partially different. Further, each light-emitting element 213 is arranged on the Z direction side of the lower electrode 224. While the connection pad 214 is made of the same material as the connection pad 14 according to the first embodiment, its shape is partially different. A connection pad back surface 214B as a back surface of the connection pad 214 is formed extremely smooth similarly to the connection pad back surface 14B. Further, each light-emitting element 213 is provided with only one connection pad 214 on the -Y direction side of the light-emitting element 213.

While the insulation film 215 is made of the same material as the insulation film 15 according to the first embodiment, its shape is partially different. Further, each light-emitting element 213 is provided with only one insulation film 215 on the -Y direction side of the light-emitting element 213. While the wiring part 216 is made of the same material as the wiring part 16 according to the first embodiment, its shape is partially different. Further, each light-emitting element 213 is provided with only one wiring part 216 on the -Y direction side of the light-emitting element 213.

While the cover layer 217 is made of the same material as the cover layer 17 according to the first embodiment, its shape is partially different. Further, the cover layer 217 is provided also in part corresponding to the base film 12 in the first embodiment. Namely, on the complex film 202, a complex film back surface 202B is formed by the connection pad back surfaces 214B, the lower electrode back surface 224B and a back surface of the cover layer 217. The cover layer 217 is referred to also as a "protective member".

Further, similarly to the electronic structure 1 according to the first embodiment, in the electronic structure 201, the outline of the support layer 211 is one step smaller than the outline of the cover layer 217 (i.e., the outline of the complex film 202) in regard to the X direction and the Y direction.

### [2-2. Manufacture of Electronic Structure and Peeling and Mounting of Complex film]

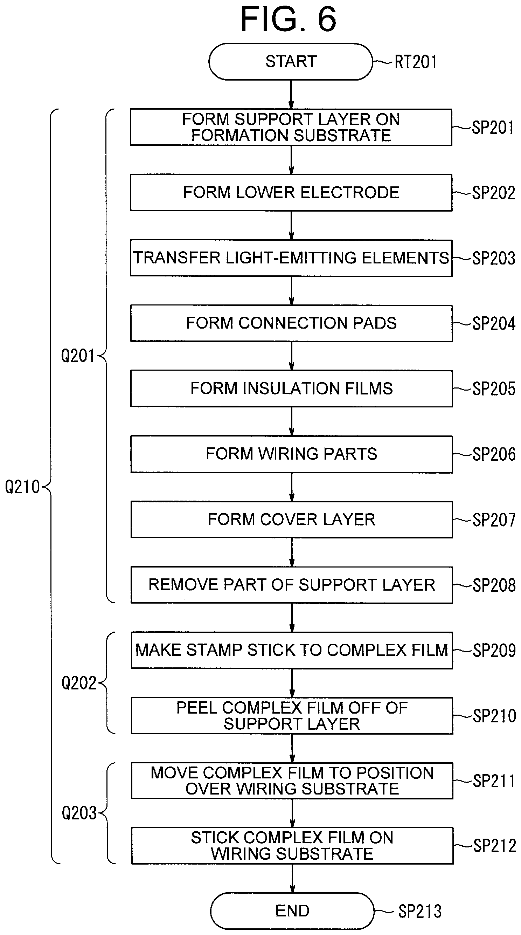

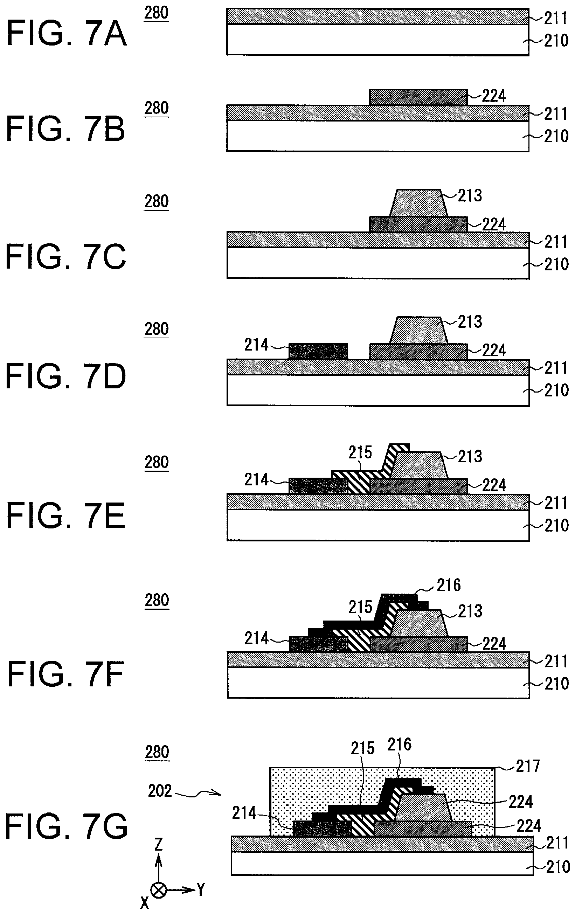

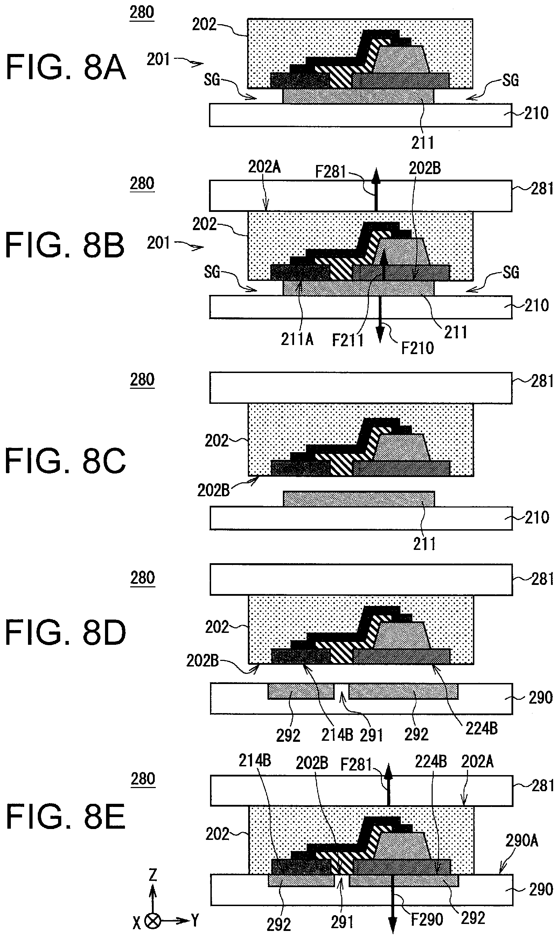

Next, the manufacture of the electronic structure 201 and the peeling and the mounting of the complex film 202 will be described below with reference to Fig. 6, Figs. 7A to 7G and Figs. 8A to 8E corresponding to Fig. 2, Figs. 3A to 3G and Figs. 4A to 4E. Fig. 6 is a flowchart showing a manufacture peeling mounting procedure in regard to the manufacture of the electronic structure 201 and the peeling and the mounting of the complex film 202. Figs. 7A to 7G and Figs. 8A to 8E are schematic cross-sectional views showing a manufacturing process of the electronic structure 201 and the complex film 202 stepwise. Here, similarly to the first embodiment, the Z direction side is represented also as the "upper side", and the -Z direction side is represented also as the "lower side".

Similarly to the first embodiment, the electronic structure 201 is manufactured by a manufacture peeling mounting apparatus 280 replacing the manufacture peeling mounting apparatus 80 according to various processes similar to those used when manufacturing generic semiconductors, so as to overlay layers on the formation substrate 210 stepwise.

Specifically, the manufacture peeling mounting apparatus 280 starting the manufacture peeling mounting procedure RT201 (Fig. 6) advances to the first step SP201. In the step SP201, similarly to the first embodiment, the manufacture peeling mounting apparatus 280 forms the support layer 211 on a front surface of the formation substrate 210 as shown in Fig. 7A, and advances to the next step SP202.

In the step SP202, the manufacture peeling mounting apparatus 280 forms the lower electrode 224 as shown in Fig. 7B, and advances to the next step SP203. Specifically, the manufacture peeling mounting apparatus 280 forms the lower electrode 224 by depositing metallic material such as Au or Pt like a thin film by a method like lithography or vapor deposition, for example. At that time, the lower electrode back surface 224B of the lower electrode 224 is formed in the state of being in contact (close contact) with the support layer front surface 211A, and thus is formed extremely flat.

Thereafter, in the steps SP203 to SP208, the manufacture peeling mounting apparatus 280 manufactures the electronic structure 201 as shown in Fig. 7C to Fig. 7G and Fig. 8A by executing steps similar to the steps SP3 to SP8 (Fig. 2). These steps are hereinafter referred to as a "manufacturing step set Q201".

In step SP209, similarly to the step SP9 (Fig. 2), the manufacture peeling mounting apparatus 280 makes a stamp 281 having the sticking function stick to a complex film front surface 202A as shown in Fig. 8B, and advances to the next step SP210. Here, in the electronic structure 201 with the stamp 281 sticking thereto, force magnitude relationship similar to that in the first embodiment holds in four types of objects: the formation substrate 210, the support layer 211, the complex film 202 and the stamp 281 successively overlaid in the Z direction.

Namely, relatively strong sticking force F210 acts between the formation substrate 210 and the support layer 211 both made of inorganic material. Further, relatively strong sticking force F281 acts between the stamp 281 and the complex film front surface 202A since the complex film front surface 202A substantially in its whole range is in contact with the stamp 281.

In contrast, relatively weak sticking force F211 acts between the support layer 211 being inorganic material and the cover layer 217 being organic material due to the relatively small area of the support layer 211, the acting of Van der Waals force, and so forth. Namely, the sticking force F211 is weaker than both of the sticking force F210 and the sticking force F281.

In the step SP210, similarly to the step SP10 (Fig. 2), the manufacture peeling mounting apparatus 280 shifts the stamp 281 in the Z direction in a state in which the formation substrate 210 is fixed by a prescribed fixation jig (not shown), and advances to the next step SP211. Accordingly, in the electronic structure 201 with the stamp 281 sticking thereto, peeling occurs at the part where the sticking force is the weakest, namely, between the cover layer 217 and the support layer 211, as shown in Fig. 8C and the complex film 202 is separated from the support layer 211 and the formation substrate 210.

As above, the manufacture peeling mounting apparatus 280 is capable of peeling the complex film 202 in the electronic structure 201 from the formation substrate 210 and the support layer 211 by the steps from the step SP209 to the step SP210 similarly to the first embodiment. These steps are hereinafter referred to as a "peeling step set Q202".

Subsequently, in the steps SP211 and SP212, the manufacture peeling mounting apparatus 280 executes processing similar to the steps SP11 and SP12 (Fig. 2). By this processing, as shown in Figs. 8D and 8E, the manufacture peeling mounting apparatus 280 sticks and mounts the complex film 202 on a mounting part 291 provided on a wiring substrate front surface 290A of a wiring substrate 290 and thereafter separates the stamp 281 from the complex film 202. Accordingly, on the complex film 202, the complex film back surface 202B is stuck on the mounting part 291 of the wiring substrate front surface 290A, and the connection pads 214 and the lower electrode 224 are electrically continued respectively to electrodes 292 of the wiring substrate 290. These steps are hereinafter referred to as a "mounting step set Q203".

In step SP213, the manufacture peeling mounting apparatus 280 ends the manufacture peeling mounting procedure RT201. For convenience of description, the manufacturing step set Q201 from the step SP201 to the step SP208, the peeling step set Q202 from the step SP209 to the step SP210, and the mounting step set Q203 from the step SP211 to the step SP212 are hereinafter referred to collectively as a "manufacture peeling mounting step set Q210".

### [2-3. Effect and Other Features]

In the above-described configuration, the electronic structure 201 according to the second embodiment is made by forming the formation substrate 210 and the support layer 211 stacked in the lower side with inorganic material while forming the cover layer 217 of the complex film 202 stacked in the upper side with organic material. Further, in the electronic structure 201, the outline of the support layer 211 is formed to be one step smaller than the outline of the cover layer 217 (Figs. 5A and 5B).

Accordingly, similarly to the first embodiment, in the electronic structure 201, the sticking force acting between the complex film back surface 202B and the support layer front surface 2011A can be held down below the sticking force in the other parts. With this feature, in the electronic structure 201, when force is applied to the complex film 202 in a direction of separating from the formation substrate 210, the complex film 202 can be easily separated from the support layer 211 and easily peeled off of the support layer 211 (Figs. 8B and 8C).

Especially in the electronic structure 201, the light-emitting elements 213 are arranged on the upper side of the lower electrode 224 and only one connection pad 214 is provided corresponding to one light-emitting element 213. Accordingly, in the electronic structure 201, the area occupied by one complex film 202 on an XY plane can be reduced compared to the electronic structure 1 according to the first embodiment and production efficiency can be increased.

Also in regard to other features, the electronic structure 201 according to the second embodiment can achieve effect similar to that in the first embodiment.

With the configuration described above, in the electronic structure 201 according to the second embodiment, the formation substrate 210 and the support layer 211 are formed with inorganic material while the cover layer 217 of the complex film 202 is formed with organic material, and the outline of the support layer 211 is formed to be smaller than the outline of the cover layer 217. Therefore, the electronic structure 201 is capable of appropriately adjusting the sticking force acting between the complex film back surface 202B and the support layer front surface 211A so that the peeling does not occur during storage and conveyance and the peeling can be executed with ease by using the stamp 281 before the mounting. Accordingly, with the electronic structure 201, storage and conveyance can be done with ease while maintaining the smoothness of the complex film back surface 202B, and the peeling of the complex film 202 off of the support layer 211 and the mounting of the complex film 202 on the wiring substrate 290 can also be executed with ease.

### [3. Third Embodiment]

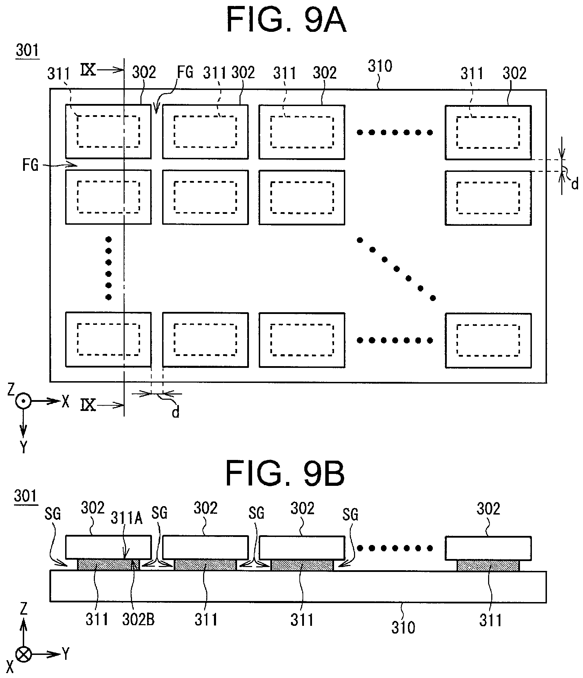

Fig. 9A is a schematic plan view showing the configuration of an electronic structure 301 according to a third embodiment. Fig. 9B is a schematic cross-sectional view showing a cross section at the line IX-IX in Fig. 9A. The electronic structure 301 has a configuration in which a plurality of support layers 311 are provided on a formation substrate 310 and a plurality of complex films 302 are respectively stuck on the upper side of the support layers 311.

The formation substrate 310 is similar to the formation substrate 210 in the second embodiment (Fig. 5A, Fig. 5B, etc.) in the constituent material and in that the surface on the Z direction side is extremely smooth. However, the formation substrate 310 is sufficiently larger than the formation substrate 210 in size in regard to the X direction and the Y direction.

On the upper side (Z direction side) of the formation substrate 310, a plurality of complex films 302 are arranged like a grid in the X direction and the Y direction. A film gap FG is formed at each part where complex films 302 adjoin each other in the X direction or the Y direction, and its spacing is a distance d. The complex film 302 is hereinafter referred to also as a "functional unit" or "functional film" or "composite film."

Each complex film 302 and each support layer 311 are respectively formed similarly to the complex film 202 and the support layer 211 according to the second embodiment. Namely, a complex film back surface 302B as a back surface of each complex film 302 and a support layer front surface 311A of each support layer 311 are formed extremely flat. Further, the outline of the support layer 311 on an XY plane is one step smaller than that of the complex film 302. Therefore, a support gap SG is formed around the support layer 311.

For the electronic structure 301, a procedure similar to the manufacturing step set Q201 in the second embodiment (Fig. 6, Figs. 7A to 7G and Figs. 8A to 8E) is executed at a plurality of positions on the upper side of the formation substrate 310 in parallel. In this case, the electronic structure 301 is manufactured stepwise by a manufacture peeling mounting apparatus 380 (details will be described later) replacing the manufacture peeling mounting apparatus 280.

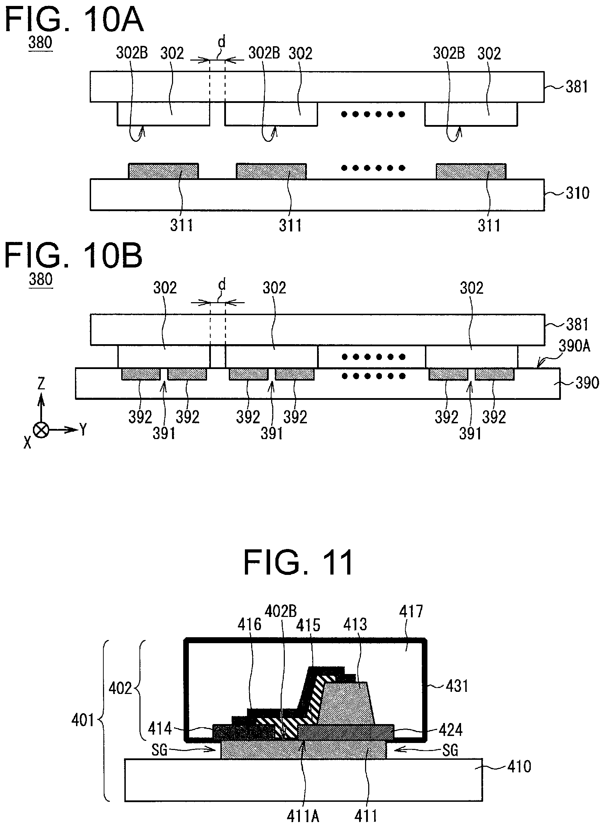

Subsequently, as shown in Fig. 10A corresponding to Fig. 8C, the manufacture peeling mounting apparatus 380 performs a procedure similar to the peeling step set Q202 in the second embodiment (Fig. 6 and Figs. 8A to 8E) on the complex films 302 of the electronic structure 301 in parallel.

Specifically, the manufacture peeling mounting apparatus 380 makes a stamp 381 stick to the complex films 302 and thereby peels the complex films 302 off of the support layers 311. At that time, the complex films 302 maintain the state of having been neatly arranged like a grid on an XY plane and maintain the spacing between complex films 302 unchanged at the distance d.

Subsequently, as shown in Fig. 10B corresponding to Fig. 8E, the manufacture peeling mounting apparatus 380 performs a procedure similar to the mounting step set Q203 in the second embodiment (Fig. 6 and Figs. 8A to 8E) on the complex films 302 in parallel. Specifically, the manufacture peeling mounting apparatus 380 sticks and mounts the complex films 302 respectively on a plurality of mounting parts 391 provided on a wiring substrate front surface 390A of a wiring substrate 390 and thereafter separates the stamp 381 from the complex films 202.

Accordingly, on each complex film 302, the complex film back surface 302B is mounted on the mounting part 391 of the wiring substrate front surface 390A, and the connection pads 214 and the lower electrode 224 are electrically continued respectively to electrodes 392 of the wiring substrate 390. Further, at that time, the complex films 302 maintain the state of having been neatly arranged like a grid on an XY plane and maintain the spacing between complex films 302 unchanged at the distance d. Parenthetically, the wiring substrate 390 on which the complex films 302 have been mounted is, for example, a display panel to be installed in an LED display device, in which one complex film 302 corresponds to one pixel (picture element).

In the above-described configuration, the electronic structure 301 according to the third embodiment is made by arranging a plurality of support layers 311 and complex films 302 like a grid on the front surface of the formation substrate 310 (Figs. 9A and 9B). The manufacture peeling mounting apparatus 380 makes the stamp 381 stick to the complex films 302, and thereby peels the complex films 302 off of the support layers 311 at the same time and sticks the complex films 302 on the mounting parts 391 of the wiring substrate 390 (Figs. 10A and 10B).

Namely, with the electronic structure 301, a plurality of complex films 302 can be mounted on the wiring substrate 390 just by executing the peeling process and the mounting process only once, and thus working efficiency can be increased markedly compared to the second embodiment.

Further, the manufacture peeling mounting apparatus 380 maintains the arrangement of the complex films 302 while the stamp 381 sticks to the plurality of complex films 302 and then these complex films 302 are stuck on the wiring substrate 390. Namely, the complex films 302 are maintained in the state of having been arranged like a grid and the spacing between complex films 302 is also maintained unchanged at the distance d.

Incidentally, suppose that the manufacture peeling mounting apparatus uses the stamp 281 according to the second embodiment (Figs. 8A to 8E), the manufacture peeling mounting apparatus is necessitated to repeat the work of peeling one complex film 302 off of the formation substrate 310 and sticking the complex film 302 on the mounting part 391 of the wiring substrate 390. In this case, the manufacture peeling mounting apparatus needs to adjust the position of the complex film 302 to the mounting part 391 on the wiring substrate 390.

Especially in cases where the wiring substrate 390 is a display panel and each complex film 302 represents one pixel (picture element), position adjustment with extremely high accuracy is required when mounting each complex film 302. However, in the mounting process executed by the manufacture peeling mounting apparatus, there is a possibility of causing displacement and there is also a possibility of needing a considerable time for the position adjustment.

In this regard, with the electronic structure 301 according to the third embodiment, the positions of the complex films 302 and the support layers 311 on the formation substrate 310 can previously be set appropriately in accordance with arrangement and spacing of the mounting parts 391 on the wiring substrate 390. Put another way, with the electronic structure 301, the spacing between complex films 302 can be optimized on the formation substrate 310 with positional accuracy of exposure processing or the like in the semiconductor manufacture process, and the complex films 302 can be mounted on the wiring substrate 390 while maintaining the spacing.

Namely, with the electronic structure 301, by using the stamp 381 (Figs. 10A and 10B) of the manufacture peeling mounting apparatus 380, the complex films 302 can be mounted on the wiring substrate 390 with extremely high positional accuracy in an extremely short time necessary for executing the peeling process and the mounting process once.

Also in regard to other features, the electronic structure 301 according to the third embodiment can achieve effect similar to that in the second embodiment.

With the configuration described above, the electronic structure 301 according to the third embodiment is formed in the state of neatly arranging a plurality of support layers 311 and complex films 302 on the formation substrate 310. On that basis, by the stamp 381 of the manufacture peeling mounting apparatus 380, the plurality of complex films 302 are peeled from the electronic structure 301 while maintaining the positional relationship among the complex films and are mounted on the wiring substrate 390 while maintaining the positional relationship. Accordingly, with the electronic structure 301, storage and conveyance can be done with ease while maintaining the smoothness of the complex film back surfaces 302B, and the plurality of complex films 302 can be mounted on the mounting parts 391 of the wiring substrate 390 in a short time and with high positional accuracy.

### [4. Other Embodiments]

In the first embodiment described earlier, a description was given of the case where a silicon substrate made of silicon (Si), a glass substrate, a sapphire substrate or the like is used as the formation substrate 10. However, the embodiments of the present disclosure are not limited to such cases and substrates formed with various other inorganic materials may be used as the formation substrate 10. In this case, it is permissible if the front surface of the formation substrate 10 is formed extremely smooth, e.g., its surface roughness is less than or equal to 10 [nm]. The same goes for the second and third embodiments.

In the first embodiment described earlier, a description was given of the case where the support layer 11 is formed as an oxide film or a nitride film made of silicon oxide (SiO₂) or silicon nitride (SiN). However, the support layer 11 is not limited to such cases and may be formed as a thin film made of a variety of oxide or nitride or a variety of other inorganic material. In this case, it is permissible if the support layer front surface 11A can be formed extremely smooth and the support gap SG can be formed by removing part of the support layer 11 by the etching process in the step SP8 of the manufacture peeling mounting procedure RT1 (Fig. 2). The same goes for the second and third embodiments.

In the first embodiment described earlier, a description was given of the case where the length of a side of the complex film 2 extending in the X direction or the Y direction is set at approximately 30 [µm] to 50 [µm] and the outline of the support layer 11 is situated on the inner side of the outline of the complex film 2 by approximately 5 [µm]. However, the complex film 2 is not limited to such cases and may be formed in various other sizes, such as setting the length of a side of the complex film 2 extending in the X direction or the Y direction at approximately 1 [mm] to 2 [mm] and situating the outline of the support layer 11 on the inner side of the outline of the complex film 2 by approximately 20 [µm]. The same goes for the second and third embodiments.

In the first embodiment described earlier, a description was given of the case where the connection pad 14 is formed with Au or Pt. However, it is also possible, for example, to form the connection pad 14 with metallic material having electrical conductivity such as Cu or Al, or alloy of multiple types of materials. In such cases, it is desirable to select an etching solution that minimizes the damaging to the surface of the connection pad 14 in the step SP8 of the manufacture peeling mounting procedure RT1 (Fig. 2). The same goes for the connection pad 214 and the lower electrode 224 in the second embodiment and also for the third embodiment.

In the first embodiment described earlier, a description was given of the case where the base film 12 and the cover layer 17 of the complex film 2 is made of organic material, the support layer 11 is made of inorganic material, and part of the support layer 11 is removed by the etching process. However, the embodiments of the present disclosure are not limited to such cases and it is also possible, for example, to protect the complex film with inorganic material while forming the support layer with organic material and remove part of the support layer by the etching process.

Specifically, an electronic structure 401 can be formed as shown in Fig. 11 corresponding to Fig. 5B, for example. The electronic structure 401 has a configuration in which a formation substrate 410, a support layer 411 and a complex film 402 are stacked successively. The formation substrate 410 is made of the same inorganic material as the formation substrate 210. The support layer 411 is made of organic material such as polyimide resin, for example. While the complex film 402 is formed mostly in the same way as the complex film 202, an outer peripheral part of a cover layer 417 is covered with a protective film 431 of inorganic material. In the electronic structure 401, the support gap SG can be formed by removing part of the support layer 411 by using an etching solution having high reactivity to organic material and low reactivity to inorganic material in the etching process.

In the first embodiment described earlier, a description was given of the case where the base film 12 is formed exclusively of organic material such as polyimide resin. However, the embodiments of the present disclosure are not limited to such cases and it is also possible, for example, to form the base film 12 with mixed material containing filler of inorganic material or the like while using organic material as the principal component, for a purpose like improving a variety of characteristic. In this case, the ratio of the inorganic material to the organic material is desired to be set less than or equal to approximately 10% in volume ratio. The same goes for the cover layer 17.

Further, also for the support layer 11 and the formation substrate 10, it is also possible to form the layer/substrate with mixed material containing filler of organic material or the like while using inorganic material as the principal component, besides forming the layer/substrate exclusively with inorganic material. The same goes for the second and third embodiments.

In the first embodiment described earlier, a description was given of the case where the formation substrate 10 is formed exclusively of inorganic material. However, the embodiments of the present disclosure are not limited to such cases and it is also possible, for example, to improve a variety of characteristic such as smoothness by performing a variety of processing/treatment such as coating on the front surface of the inorganic material.

It is also possible to form the formation substrate 10 in multilayer structure in which multiple types of materials are stacked properly, instead of single layer structure made of one type of material. Alternatively, it is also possible to perform a variety of processing/treatment on a surface of organic material such as the base film 12 or the cover layer 17. The same goes for the second and third embodiments.

In the first embodiment described earlier, a description was given of the case where part of the support layer 11 is removed by using an etching solution in the liquid form in the step SP8 of the manufacture peeling mounting procedure RT1 (Fig. 2). However, the embodiments of the present disclosure are not limited to such cases and it is also possible, for example, to remove part of the support layer 11 by using an etching gas in the gaseous form. The same goes for the second and third embodiments.

In the first embodiment described earlier, a description was given of the case where three light-emitting elements 13 are provided in the complex film 2 and have light emission colors different from each other. However, the embodiments of the present disclosure are not limited to such cases and it is also possible, for example, to provide two or less or four or more light-emitting elements 13 in the complex film 2. Namely, it is permissible if the number of light-emitting elements 13 provided in the complex film 2 is one or more. In this case, it is permissible even if the light-emitting elements have light emission colors different from each other or at least some of the light-emitting elements have the same light emission color. Further, the arrangement of the light-emitting elements 13 is not limited to the linear arrangement in the X direction but a variety of arrangement may be employed. The same goes for the second and third embodiments.

In the first embodiment described earlier, a description was given of the case where the complex film 2 is provided with light-emitting elements 13 (namely, LEDs). However, the embodiments of the present disclosure are not limited to such cases and it is also possible, for example, to provide the complex film 2 with a variety of elements having a variety of electronic functions, such as electronic elements like resistors, capacitors, light-receiving elements, piezoelectric elements or a variety of sensor elements or semiconductor elements like transistors or ICs (Integrated Circuits). Also in such cases, it is permissible even if one complex film 2 is provided with a plurality of electronic elements or the like, or electronic elements or the like of the same type or different types are properly combined. The same goes for the second and third embodiments.

In the first embodiment described earlier, a description was given of the case where two connection pads 14 are associated with one light-emitting element 13 in the complex film 2. Further, in the second embodiment, a description was given of the case where one connection pad 214 and one lower electrode 224 are associated with one light-emitting element 213 and three light-emitting elements 213 are associated with one lower electrode 224. However, the embodiments of the present disclosure are not limited to such cases and it is also possible to associate one electronic element with an arbitrary number of connection pads or lower electrodes.

In the first embodiment described earlier, a description was given of the case where the wiring substrate 90 is implemented as a circuit board formed principally of glass epoxy. However, the embodiments of the present disclosure are not limited to such cases and it is also possible, for example, to implement the wiring substrate 90 as a variety of circuit board such as a film-like flexible circuit board. In this case, it is permissible if the complex film 2 is enabled to stick to the circuit board by forming the front surface of the circuit board extremely smooth. The same goes for the second and third embodiments.

In the first embodiment described earlier, a description was given of the case where the stamp 81's sticking force F81 acting on the complex film 2 is kept constant. On that basis, the sticking force F81 is set so as to be stronger than the sticking force F11 (Fig. 4B) in the step SP9 of the manufacture peeling mounting procedure RT1 (Fig. 2) and weaker than the sticking force F90 (Fig. 4E) in the step SP12. However, the embodiments of the present disclosure are not limited to such cases and it is also possible, for example, to make it possible to change the magnitude of the sticking force F81 at the stamp 81. In this case, it is desirable to increase the sticking force F81 in the step SP9 and decrease the sticking force F81 in the step SP12, for example. With this feature, restriction regarding the sticking force that should be satisfied by each of the support layer 11 and the complex film 2 can be relaxed significantly and the degree of freedom in design can be increased. The same goes for the second and third embodiments.

In the third embodiment described earlier, a description was given of the case where the complex films 302 are arranged like a grid on an XY plane (Figs. 9A and 9B) in regard to the arrangement of the complex films 302 in the electronic structure 301. However, the embodiments of the present disclosure are not limited to such cases and it is also possible, for example, to arrange the complex films 302 according to a variety of arrangement pattern such as a hound's tooth check pattern. What is essential is that each complex film 302 is arranged at a position corresponding to its respective mounting part 391 on the wiring substrate 390.

In the third embodiment described earlier, a description was given of the case where the spacing between complex films 302 is set at the distance d in regard to both the X direction and the Y direction. However, the embodiments of the present disclosure are not limited to such cases and it is also possible, for example, to set the spacing in the X direction and the spacing in the Y direction differently from each other or to arrange the complex films 302 at non-constant intervals. Also in such cases, what is essential is that each complex film 302 is arranged at a position corresponding to its respective mounting part 391 on the wiring substrate 390.

Further, the present invention is not limited to the embodiments and other embodiments described above. Namely, the scope of application of the present invention ranges also to embodiments obtained by arbitrarily combining part or all of the above-described embodiments and part or all of the above-described other embodiments and embodiments obtained by extracting parts from the above-described embodiments and the above-described other embodiments.

Furthermore, in the embodiments described earlier, a description was given of the case where the electronic structure 1 as an electronic functional structure is formed with the formation substrate 10 as a substrate, the complex film 2 as a functional unit and the support layer 11 as a support layer. However, the embodiments of the present disclosure are not limited to such cases and it is also possible to form the electronic structure with a substrate made in a variety of different configuration, the functional unit and the support layer.

The embodiments of the present disclosure are applicable to cases where a display panel to be installed in an LED display device is manufactured, for example.

### [5. DESCRIPTION OF REFERENCE CHARACTERS]

1, 201, 301: electronic structure, 2, 202, 302: complex film, 2A, 202A: complex film front surface, 2B, 202B, 302B: complex film back surface, 10, 210, 310: formation substrate, 10A: formation substrate front surface, 11, 211, 311: support layer, 11A, 211A, 311A: support layer front surface, 12: base film, 12B: base film back surface, 13, 213: light-emitting element, 14, 214: connection pad, 14B, 214B: connection pad back surface, 17, 217: cover layer, 80, 280, 380: manufacture peeling mounting apparatus, 81, 281, 381: stamp, 90, 290, 390: wiring substrate, 90A, 290A, 390A: wiring substrate front surface, 91, 291, 391: mounting part, 92, 292, 392: electrode, 224: lower electrode, 224B: lower electrode back surface, F10, F11, F81, F90, F210, F211, F281: sticking force, FG: film gap, SG: support gap, d: distance, Q1, Q201: manufacturing step set, Q2, Q202: peeling step set, Q3, Q203: mounting step set, Q10, Q210: manufacture peeling mounting step set.

## Claims

1. An electronic structure (1, 201, 301) comprising:
a substrate (10) having a first surface (10A);
a functional unit (2, 202, 302) including a functional section (13, 16, 14) that has an electronic function and a protective member (12, 17, 217) that protects the functional section (13, 16, 14) and having a second surface (2B) formed on the first surface (10A)'s side; and
a support layer (11, 211, 311) provided at a position to contact the first surface (10A) and having a third surface (11A) in contact with the second surface (2B) of the functional unit (2), area of the third surface (11A) being smaller than area of the second surface (2B),
wherein one of part of the functional unit (2, 202, 302) forming the second surface (2B) of the protective member (12, 17, 217) and part of the support layer (11, 211, 311) forming the third surface (11A) contains organic material as its principal component and the other contains inorganic material as its principal component.

2. The electronic structure (1, 201, 301) according to claim 1, wherein
the part forming the second surface (2B) of the protective member (12, 17, 217) contains organic material as its principal component,
the part of the support layer (11, 211, 311) forming the third surface (11A) contains inorganic material as its principal component, and
part of the substrate (10) forming the first surface (10A) contains inorganic material as its principal component.

3. The electronic structure (1, 201, 301) according to claim 2, wherein
the part forming the second surface (2B) of the protective member (12, 17, 217) is made of resin, and
the part of the support layer (11, 211, 311) forming the third surface (11A) is made of oxide or nitride.

4. The electronic structure (1, 201, 301) according to claim 2 or 3, wherein
the part forming the second surface (2B) of the protective member (12, 17, 217) is made of polyimide, and
the part of the support layer (11, 211, 311) forming the third surface (11A) is made of silicon oxide.

5. The electronic structure (1, 201, 301) according to any one of claims 1 to 4, wherein
the functional section includes a functional element (13) and a conductive member (14),
the conductive member (14) has a fourth surface (14B) that forms part of the second surface (2B), and
the third surface (11A) of the support layer (11, 211, 311) is in contact with at least part of the fourth surface (14B).

6. The electronic structure (1, 201, 301) according to claim 5, wherein the functional element (13) is electrically connected to the conductive member (14) by a wiring member having electrical conductivity.

7. The electronic structure (1, 201, 301) according to claim 5, wherein the conductive member (14) is a metallic film.

8. The electronic structure (1, 201, 301) according to claim 7, wherein the metallic film is gold, platinum, or alloy containing at least one of gold and platinum.

9. The electronic structure (1, 201, 301) according to any one of claims 1 to 8, further comprising a base film (12) that is part of the protective member (12, 17, 217) and forms part of the second surface (2B),
wherein the functional section (13, 16, 14) is provided on a surface of the base film (12) on a side opposite to the second surface (2B, 12B).

10. The electronic structure (1, 201, 301) according to any one of claims 1 to 4, wherein
the functional section includes a functional element (13) and a conductive member (14),
the conductive member (14) forms part of the second surface (2B), and
the functional element (13) is provided on a surface of the conductive member (14) on a side opposite to the second surface (2B) .

11. The electronic structure (1, 201, 301) according to any one of claims 1 to 10, wherein
a plurality of the functional units (2, 202, 302) are arranged at positions to face the first surface (10A) of the substrate (10), and
a plurality of the support layers (311) are respectively provided at positions on the first surface (10A) of the substrate (10) corresponding to the plurality of functional units (2, 202, 302) .

12. A method of manufacturing a complex film (2, 202, 302), comprising:
forming a substrate (10) having a first surface (10A);
forming a support layer (11, 211, 311) having a third surface (11A) on the first surface (10A);
forming a complex film (2, 202, 302), including a functional section (13, 16, 14) that has an electronic function and a protective member (12, 17, 217) that protects the functional section (13, 16, 14) and having a second surface (2B) formed on the third surface (11A)'s side, on the support layer (11, 211, 311); and
removing part of the support layer (11, 211, 311) and thereby making area of the third surface (11A), in contact with the complex film (2, 202, 302) in remaining part of the support layer (11, 211, 311), smaller than area of the second surface (2B),
wherein one of part of the complex film (2, 202, 302) forming the second surface (2B) of the protective member (12, 17, 217) and part of the support layer (11, 211, 311) forming the third surface (11A) contains organic material as its principal component and the other contains inorganic material as its principal component.

13. The method of manufacturing a complex film (2, 202, 302) according to claim 12, further comprising:
peeling the second surface (2B) of the complex film (2, 202, 302) off of the third surface (11A) of the support layer (11, 211, 311) by applying force to the complex film (2, 202, 302) in a direction of separating from the substrate (10) after making the area of the third surface (11A) smaller than the area of the second surface (2B).

14. The method of manufacturing a complex film (2, 202, 302) according to claim 13, further comprising:
sticking the complex film (2, 202, 302) on a wiring substrate (90, 290, 390) by placing the second surface (2B) of the complex film (2, 202, 302) in contact with a wiring substrate front surface (90A, 290A, 390A) of the wiring substrate (90, 290, 390) after peeling the second surface (2B) off of the third surface (11A).
